# EUROPEAN PATENT SPECIFICATION

(11) **EP 3 813 503 B1**
(45) Date of publication and mention of the grant of the patent: **20.09.2023**
(21) Application number: 18924319.9
(22) Date of filing: 25.06.2018
(51) Int. Cl.: H05K 13/08, H05K 13/04

(54) **ELECTRONIC COMPONENT MOUNTING DEVICE AND CONTROL METHOD**
VORRICHTUNG ZUR MONTAGE EINER ELEKTRONISCHEN KOMPONENTE UND STEUERUNGSVERFAHREN
DISPOSITIF DE MONTAGE DE COMPOSANTS ÉLECTRONIQUES ET PROCÉDÉ DE COMMANDE

(43) Date of publication of application: 28.04.2021
(73) Proprietor: Fuji Corporation, Chiryu-shi, Aichi 472-8686 (JP)
(72) Inventor: NAKAYAMA, Yukinori, Chiryu-shi, Aichi 472-8686 (JP); SUGIURA, Satoshi, Chiryu-shi, Aichi 472-8686 (JP)
(74) Representative: Grünecker Patent- und Rechtsanwälte PartG mbB
(86) International application number: PCT/JP2018/023929
(87) International publication number: WO 2020/003338

(56) References cited:
- WO-A1-2016/092651
- WO-A1-2017/056239
- DE-T5-112015 006 861
- JP-A- 2005 072 046
- JP-A- 2006 041 158
- JP-A- 2013 206 907
- JP-A- 2015 070 176

## Description

### Technical Field

The present invention relates to an electronic component mounting device.

### Background Art

Conventionally, there is an electronic component mounting device which picks up a component and mounts the component on a board using a suction nozzle provided on a rotary head. There is a technique of imaging the suction nozzle at a pre-imaging position (a leading position) and the post-imaging position (a trailing position) of a lifting and lowering position (a work position) at which the suction nozzle is lifted and lowered, and inspecting whether the pickup or the mounting of the component has been appropriately performed by, for example, judging the presence or absence of the component (for example, Patent Literature 1).

When the suction nozzle to be lifted and lowered next is an adjacent suction nozzle in the rotary head, since the suction nozzle to be lifted and lowered next is positioned at the pre-imaging position, it is possible to image the suction nozzle to be lifted and lowered next at the same timing as the suction nozzle is lifted and lowered. On the other hand, in a case in which the suction nozzle to be lifted and lowered next is not an adjacent suction nozzle in the rotary head, the suction nozzle to be lifted and lowered next is not positioned at the pre-imaging position although the suction nozzle is positioned at the lifting and lowering position. Therefore, a step of positioning the suction nozzle to be lifted and lowered next at the pre-imaging position arises, which is not efficient. Therefore, Patent Literature 1 discloses a technique of efficiently performing the imaging by imaging a moving suction nozzle.
DE 11 2015 006861 T5 relates to imaging two suction nozzles placed along a line through the center of a rotary assembly of suction nozzles in a component mounter machine in parallel. As the suction nozzles are imaged from opposite directions along the same line, interference may occur. To avoid interference from this arrangement and from ambient light, different wavelength filters are implemented for the two imaging directions.

### Patent Literature

Patent Literature 1:WO 2017/042929

### Summary of the Invention

### Technical Problem

Incidentally, there is an electronic component mounting device in which the rotary head includes multiple lifting and lowering positions. In such an electronic component mounting device, concerning efficiently performing imaging, there is room for improvement.

The present application has been proposed in light of the problem described above and an object thereof is to provide an electronic component mounting device and a control method capable of efficiently performing imaging by different means from that of Patent Literature 1.
The invention is defined by the features of the independent claims. Any reference to inventions or embodiments not falling within the scope of the independent claims are to be interpreted as examples useful for understanding the invention.

### Solution to Problem

The present specification discloses an electronic component mounting device comprising: a rotary head, in which multiple nozzle holders are disposed on a circumference centered on an axis, and which is configured to pivot about the axis; a suction nozzle, being held by the nozzle holder, which is configured to pick up a component; a lifting and lowering section configured to lift and lower the nozzle holder at a lifting and lowering position on the circumference for picking up or mounting the component with the suction nozzle; an imaging section configured to image the suction nozzle at a pre-imaging position and a post-imaging position on the circumference of the lifting and lowering position; and a control section configured to perform control based on job data in which an order of control steps is predetermined, wherein the control steps include at least one of a lifting and lowering process executed with the lifting and lowering section, a pre-imaging process in which the suction nozzle is imaged by the imaging section at the pre-imaging position or the post-imaging position before execution of the lifting and lowering process, and a post-imaging process in which the suction nozzle is imaged by the imaging section at the pre-imaging position or the post-imaging position after execution of the lifting and lowering process, wherein, in a case where a lifting and lowering order which is an order of the nozzle holder serving as a target of the lifting and lowering process in the job data is not an arrangement order on the circumference, the control section executes the post-imaging process targeting the nozzle holder and the lifting and lowering process of the n-th nozzle holder in the same control step, in a case where the nozzle holder of which the lifting and lowering order is earlier than when the n-th nozzle holder th is positioned at the pre-imaging position or the post-imaging position, when the n-th nozzle holder in the lifting and lowering order is positioned at the lifting and lowering position, and the control section executes the pre-imaging process targeting the nozzle holder and the lifting and lowering process of the n-th nozzle holder in the same control step, in a case where the nozzle holder of which the lifting and lowering order of the nozzle holder is later than the n-th is positioned at the pre-imaging position or the post-imaging position, when the n-th nozzle holder in the lifting and lowering order is positioned at the lifting and lowering position, wherein the pre-imaging position is a stopping position one pitch before the lifting and lowering position, and the post-imaging position is a stopping position one pitch after the lifting and lowering position.

The present specification discloses a control method of an electronic component mounting device, wherein the electronic component mounting device is provided with a rotary head, in which multiple nozzle holders are disposed on a circumference centered on an axis, and which is configured to pivot about the axis, a suction nozzle, being held by the nozzle holder, which is configured to pick up a component, a lifting and lowering section configured to lift and lower the nozzle holder at a lifting and lowering position on the circumference, an imaging section configured to image the suction nozzle at a pre-imaging position and a post-imaging position on the circumference of the lifting and lowering position, and a control section configured to perform control according to job data in which an order of control steps is predetermined, and the control steps include at least one of: a lifting and lowering process by the lifting and lowering section, a pre-imaging process in which the suction nozzle is imaged by the imaging section at the pre-imaging position or the post-imaging position before execution of the lifting and lowering process, and a post-imaging process in which the suction nozzle is imaged by the imaging section at the pre-imaging position or the post-imaging position after execution of the lifting and lowering process, and wehrein the control method comprising: in a case where a lifting and lowering order which is an order of the nozzle holder serving as a target of the lifting and lowering process in the job data is not an arrangement order on the circumference, executing the post-imaging process targeting the nozzle holder and the lifting and lowering process of the n-th nozzle holder in the same control step, in a case where the nozzle holder of which the lifting and lowering order is earlier than the n-th is positioned at the pre-imaging position or the post-imaging position, when the n-th nozzle holder in the lifting and lowering order is positioned at the lifting and lowering position, and executing the pre-imaging process targeting the nozzle holder and the lifting and lowering process of the n-th nozzle holder in the same control step, in a case where the nozzle holder of which the lifting and lowering order of the nozzle holder is later than the when the n-th nozzle holder is positioned at the pre-imaging position or the post-imaging position, when the n-th nozzle holder in the lifting and lowering order is positioned at the lifting and lowering position, wherein the pre-imaging position is a stopping position one pitch before the lifting and lowering position, and the post-imaging position is a stopping position one pitch after the lifting and lowering position.

### Advantageous Effect of the Invention

According to the present disclosure, it is possible to provide an electronic component mounting device and a control method capable of efficiently performing imaging.

### Brief Description of Drawings

[Fig. 1] Fig. 1 is a perspective view of an electronic component mounting device according to an embodiment.
[Fig. 2] Fig. 2 is a plan view of the electronic component mounting device.
[Fig. 3] Fig. 3 is a side view of a mounting head.
[Fig. 4] Fig. 4 is a diagram illustrating an imaging section.
[Fig. 5] Fig. 5 is a block diagram illustrating a control system of the electronic component mounting device.
[Fig. 6] Fig. 6 is a diagram illustrating sequence data.
[Fig. 7] Fig. 7 is a diagram illustrating mounting order data.
[Fig. 8] Fig. 8(a) is a diagram illustrating the arrangement of nozzle holders in control step 10, Fig. 8(b) is a diagram illustrating the arrangement of the nozzle holders in control step 11, and Fig. 8(c) is a diagram illustrating the arrangement of the nozzle holders in control step 12.
[Fig. 9] Fig. 9(a) is a diagram illustrating the arrangement of the nozzle holders in control step 2, Fig. 9(b) is a diagram illustrating the arrangement of the nozzle holders in control step 4, and Fig. 9(c) is a diagram illustrating the arrangement of the nozzle holders in control step 7.
[Fig. 10] Fig. 10 is a flowchart of an inspection optimization process according to a first embodiment.
[Fig. 11] Fig. 11 is a diagram illustrating sequence data after execution of the inspection optimization process according to the first embodiment.
[Fig. 12] Fig. 12 is a flowchart of an inspection optimization process according to a second embodiment.
[Fig. 13] Fig. 13 is a diagram illustrating sequence data after execution of the inspection optimization process according to the second embodiment.
[Fig. 14] Figs. 14 are diagrams illustrating a moving section, Fig. 14(a) illustrates the imaging section set to a position a, and Fig. 14(b) illustrates the imaging section set to a position b.
[Fig. 15] Fig. 15 is a flowchart of a re-optimization process according to a third embodiment.
[Fig. 16] Fig. 16 is a diagram illustrating sequence data after execution of the re-optimization process according to the third embodiment.

### Description of Embodiments

### First Embodiment

### Configuration of Electronic Component Mounting Device

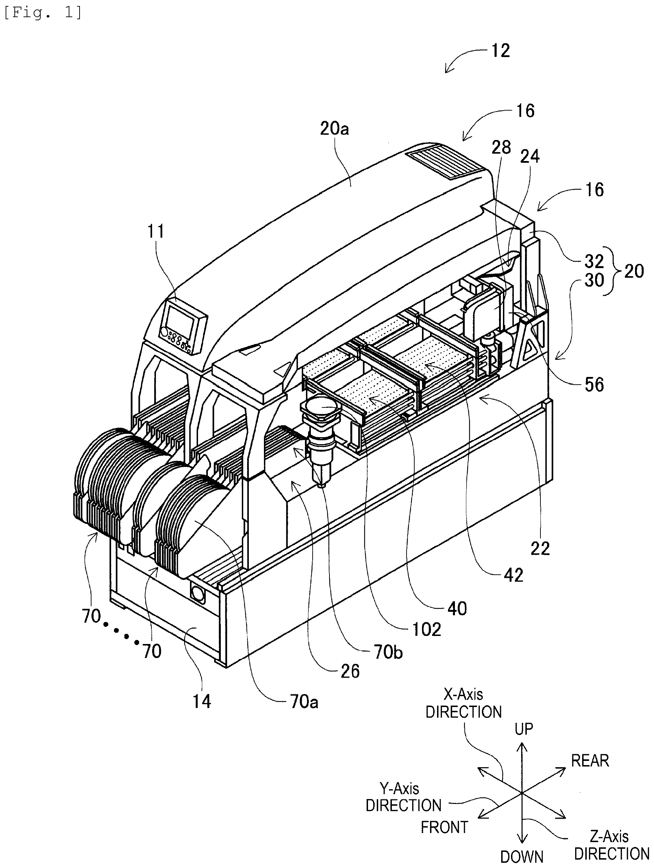

As illustrated in Fig. 1, electronic component mounting device (hereinafter, abbreviated as mounting device) 12 includes system base 14 and two mounting machines 16. Two mounting machines 16 are adjacently installed on system base 14. Mounting machine 16 includes mounting machine main body 20, conveyance device 22, mounting head moving device (hereinafter, abbreviated as moving device) 24, supply device 26, mounting head 28, upper cover 20a, part camera 102, and touch panel 11. Mounting device 12 mounts electronic components on a board such as a printed circuit board, for example, which is conveyed by conveyance device 22 to perform the work of mounting. In the following description, the directions illustrated in Fig. 1 will be used for the directions. A direction in which the board is conveyed by conveyance device 22 is an X-axis direction and a direction orthogonal to the X-axis direction is a Y-axis direction.

Mounting machine main body 20 includes frame section 30 and beam section 32 which bridges above frame section 30. Upper cover 20a is disposed above beam section 32. Touch panel 11 is disposed at the top front side of mounting machine 16, displays the operation information of mounting machine 16, and receives an instruction from an operator or the like. Part camera 102 is disposed between conveyance device 22 and supply device 26 and images the electronic components held by mounting heads 28.

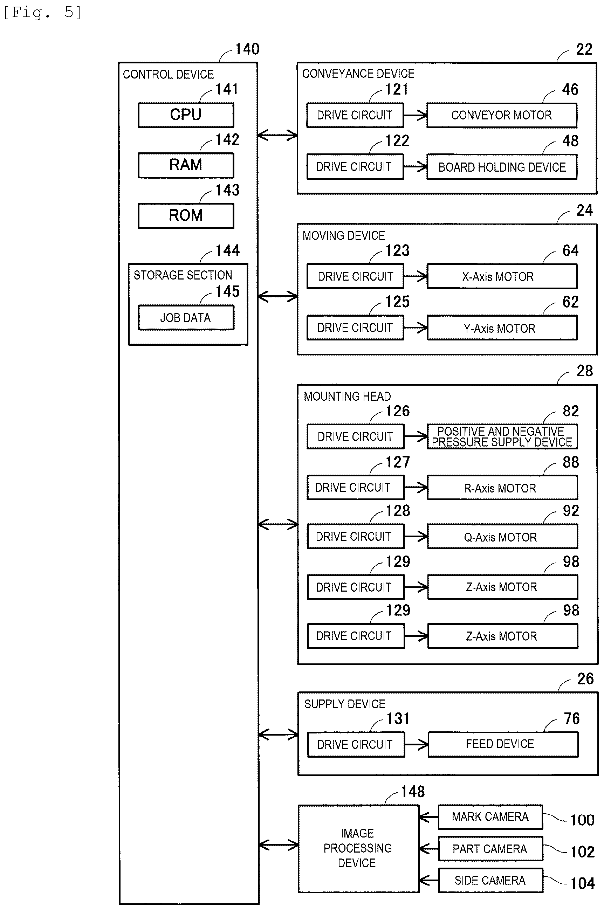

Conveyance device 22 includes two conveyor devices 40 and 42 and board holding device 48 (Fig. 5). Two conveyor devices 40 and 42 extend in the X-axis direction and are disposed in frame section 30 parallel to each other. Using conveyor motor 46 (Fig. 5) as a driving source, each of two conveyor devices 40 and 42 conveys a board supported by each conveyor device 40 and 42 in the X-axis direction. Board holding device 48 (Fig. 5) pushes up to fix the conveyed board at a predetermined position.

Supply device 26 is a feeder-type supply device and is disposed at the end section of the front side of frame section 30. Supply device 26 includes multiple tape feeders 70. Tape feeder 70 includes supply reel 70a and feed device 76 (Fig. 5). Taped electronic components are wound on supply reel 70a. Feed device 76 unseals the tape while pulling out the tape wound around supply reel 70a and feeds the electronic components to component supply section 70b at the rear end of tape feeder 70.

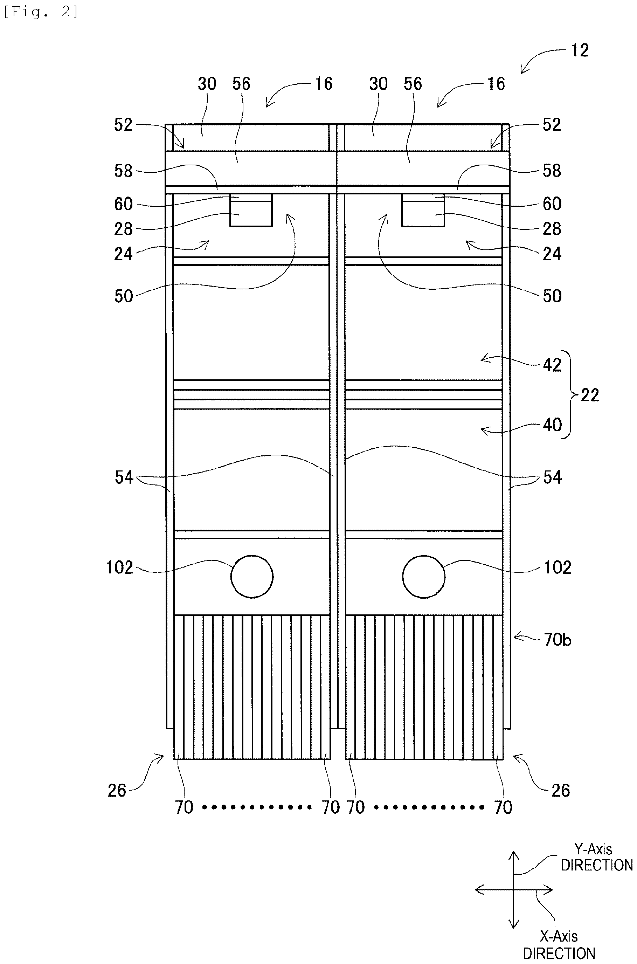

Moving device 24 will be described using Fig. 2. Fig. 2 is a plan view illustrating mounting device 12 in a state where upper cover 20a is removed from a perspective from above. Moving device 24 includes Y-axis direction slide mechanism 52 and X-axis direction slide mechanism 50 and the like. Y-axis direction slide mechanism 52 includes a pair of Y-axis direction guide rails 54 extending in the Y-axis direction, Y-axis slider 56, Y-axis motor 62 (Fig. 5), and the like. Y-axis slider 56 is guided by Y-axis direction guide rail 54 in accordance with the driving of Y-axis motor to move to any position in the Y-axis direction. X-axis direction slide mechanism 50 includes X-axis direction guide rail 58 extending in the X-axis direction, X-axis direction guide rail 58, and X-axis slider 60. X-axis direction guide rail 58 is fixed to Y-axis slider 56 and X-axis slider 60 is guided by X-axis direction guide rail 58 in accordance with the driving of X-axis motor to move to any position in the X-axis direction. Mounting head 28 which picks up and mounts the electronic component on the board is fixed to X-axis slider 60.

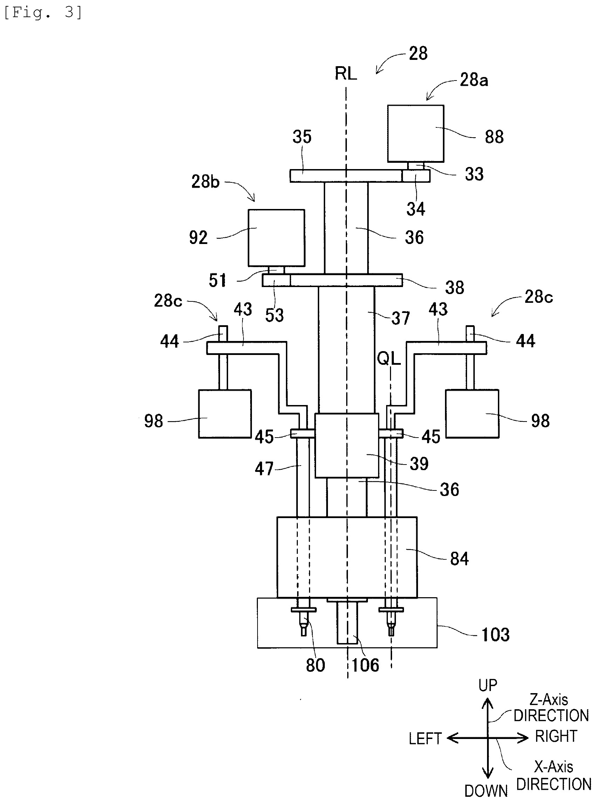

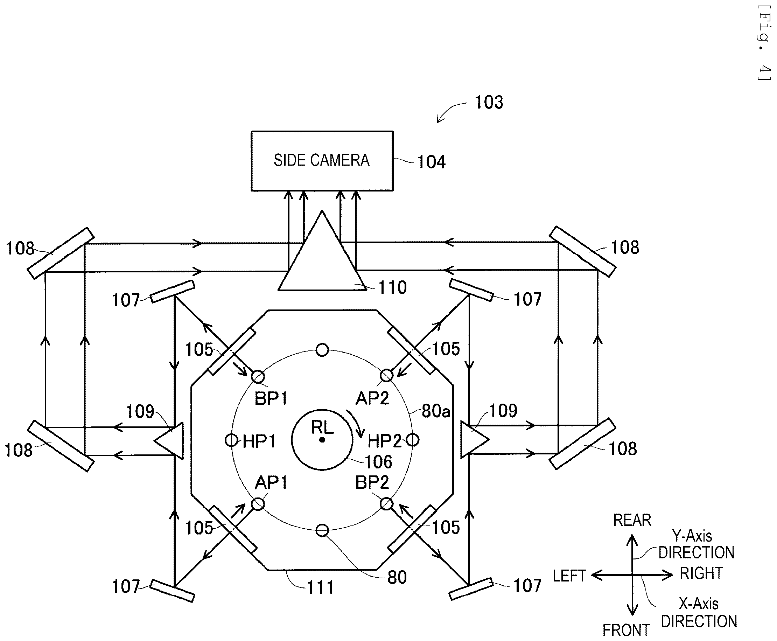

Next, mounting head 28 will be described in detail using Fig. 3. Mounting head 28 is a rotary head including R-axis driving mechanism 28a, Q-axis driving mechanism 28b, Z-axis driving mechanisms 28c, 28c, rotary section 84, nozzle gear 45, nozzle holder 47, suction nozzle 80, imaging section 103, and the like. Here, rotary section 84 is configured to hold eight nozzle holders 47 on circumference 80a concentric with R-axis line RL which is the center axis of rotary section 84 (refer to Fig. 4). R-axis driving mechanism 28a, using R-axis line RL as a rotation axis, causes rotary section 84 and nozzle holder 47 to rotate. Specifically, R-axis driving mechanism 28a is intermittently rotated clockwise from a perspective from above one pitch at a time, the pitch being an angle formed between R-axis driving mechanism 28a and the adjacent nozzle holder 47 and R-axis line RL. In the following description, the position at which nozzle holder 47 on circumference 80a stops is referred to as a stopping position. Q-axis driving mechanism 28b causes suction nozzle 80 to rotate using Q-axis line QL, which is a center axis of suction nozzle 80, as a rotation axis. Z-axis driving mechanism 28c individually lifts and lowers nozzle holder 47 in an up-down direction at each lifting and lowering position HP1 and HP2 (refer to Fig. 4) which are two positions among the eight stopping positions. In the following description, there are cases in which Z-axis-driving mechanism 28c is referred to as Z-axis, Z-axis driving mechanism 28c corresponding to lifting and lowering position HP1 is referred to as Z1-axis, and Z-axis driving mechanism 28c corresponding to the lifting and lowering position HP2 is referred to as Z2-axis. In Fig. 3, the depiction of nozzle holders 47 other than nozzle holder 47 positioned at lifting and lowering positions HP1 and HP2 is omitted.

R-axis driving mechanism 28a includes R-axis motor 88 which is an electromagnetic motor, rotary shaft 33, gears 34 and 35, and R-shaft 36. Gear 35 is fixed to an upper end portion of R-shaft 36, cylindrical rotary section 84 concentric with R-shaft 36 is fixed to a lower end portion of R-shaft 36. Rotary shaft 33 is a rotary shaft of R-axis motor 88 and gear 34 is fixed to the lower end portion. Gear 35 and gear 34 mesh with each other. Accordingly, the drive force of R-axis motor 88 is transmitted to R-shaft 36 and rotary section 84 rotates about R-axis line RL.

Q-axis driving mechanism 28b includes Q-axis motor 92 which is an electromagnetic motor, rotary shaft 51, gear 53, and Q-shaft 37. Q-shaft 37 includes gears 38 and 39. Gear 38 is fixed to an upper end portion of Q-shaft 37 and gear 39 is fixed to a lower end portion of Q-shaft 37. Rotary shaft 51 is a rotary shaft of Q-axis motor 92. Gear 53 and gear 38 mesh with each other. Accordingly, the drive force of Q-axis motor 92 is transmitted to Q-shaft 37 and Q-shaft 37 and gear 39 rotate about R-axis line RL.

Z-axis driving mechanism 28c includes Z-axis motor 98 which is an electromagnetic motor, ball screw 44, Z-axis lever 43, and the like. Ball screw 44 is fixed to Z-axis motor 98 and rotates about an axis parallel to R-axis line RL. Z-axis lever 43 is an L-shaped member and a nut (not illustrated) screwed onto ball screw 44 via a ball (not illustrated) is fixed to a first end portion of Z-axis lever 43. Accordingly, the rotation of Z-axis motor 98 is converted into linear motion, is guided by a guide rail (not illustrated), and Z-axis lever 43 moves in the up-down direction. A second end portion of Z-axis lever 43 is engaged with the upper end portion of nozzle gear 45. Nozzle gear 45 is fixed to the upper end portion of nozzle holder 47 and meshes with gear 39. Accordingly, in conjunction with Q-shaft 37 which is rotated by the drive force of Q-axis motor 92, nozzle gear 45 and nozzle holder 47 rotate around Q-axis line QL.

Suction nozzle 80 is attached to and held by the lower end portion of nozzle holder 47. Negative pressure and positive pressure are supplied to suction nozzle 80 from positive and negative pressure supply device 82 (Fig. 5) via negative pressure air and positive pressure air passages provided in nozzle holder 47. Accordingly, suction nozzle 80 picks up and holds the electronic component using the negative pressure and it is possible to detach the held electronic component using the positive pressure. Background plate 106 has a cylindrical shape having R-axis line RL as the center axis and is fixed to the lower end portion of rotary section 84. Imaging section 103 is attached to the outer periphery of suction nozzle 80 and images suction nozzle 80 positioned at a total of four locations of pre-imaging positions AP1 and AP2 (refer to Fig. 4) and post-imaging positions BP1 and BP2 (refer to Fig. 4). Incidentally, each pre-imaging position AP1 and AP2 is a stopping position one pitch before each lifting and lowering position HP1 and HP2, respectively. Each post-imaging position BP1 and BP2 is a stopping position one pitch after each lifting and lowering position HP1 and HP2, respectively. In the following description, pre-imaging positions AP1 and AP2 and post-imaging positions BP1 and BP2 are collectively referred to as the imaging positions. Lifting and lowering positions HP1 and HP2 are collectively referred to as the lifting and lowering positions.

Imaging section 103 will be described in detail using Fig. 4. Imaging section 103 includes, in a cover (not illustrated), side camera 104, four light emitting sections 105, background plate 106, four first mirrors 107, four second mirrors 108, two first prisms 109, and second prism 110. Light emitting section 105 includes an LED (Light Emitting Diode) (not illustrated) and an LED drive circuit (not illustrated) which drives the LED. Specifically, the LED and the LED drive circuit are mounted on flexible printed circuit board 111. Flexible printed circuit board 111 has a plane in the up-down direction, is curved into an octagon from a perspective from above, and LEDs are attached to face each imaging position. As illustrated by the arrow lines in Fig. 4, the light path of light emitted by each light emitting section 105 and reflected by suction nozzle 80 is changed by first mirror 107, first prism 109, two second mirrors 108, and second prism 110 and enters side camera 104. Incidentally, openings (not illustrated) for allowing light from suction nozzle 80 to pass through are formed in flexible printed circuit board 111. Side camera 104 includes, for example, an image sensor (not illustrated), receives the light, and acquires a side image of the tip portion of suction nozzle 80. Incidentally, the light from each imaging position forms an image in a different region from each other on the light-receiving surface of the image sensor. Accordingly, a side image of suction nozzle 80 positioned at each imaging position is acquired at the same time.

Next, the operation of the mounting work of mounting machine 16 will be described. The board is conveyed to a predetermined position by conveyor devices 40 and 42 and is fixed by board holding device 48. On the other hand, moving device 24 causes mounting head 28 to move to component supply section 70b of supply device 26. Rotary section 84 pivots such that nozzle holder 47, to which a predetermined suction nozzle 80 is mounted, is positioned at lifting and lowering position HP1 or HP2 (refer to Fig. 4). Nozzle holder 47, to which a predetermined suction nozzle 80 is mounted, is lowered to the position of the electronic component fed to component supply section 70b. Negative pressure is supplied to suction nozzle 80, and suction nozzle 80 picks up and holds the electronic component. Subsequently, the predetermined suction nozzle 80 is lifted. The above operations are repeated as appropriate and the electronic components are held by each of multiple suction nozzles 80.

In the holding work, the inspection by side camera 104 is performed. It is confirmed that the electronic component is not picked up on the tip end of suction nozzle 80 by the side image in which suction nozzle 80 is imaged at the imaging position before being lifted and lowered. It is confirmed that the electronic component has been picked up on the tip end of suction nozzle 80 and the posture of the picked-up electronic component is confirmed by the side image in which suction nozzle 80 is imaged at the imaging position after being lifted and lowered. The position at which suction nozzle 80 is imaged before being lifted and lowered is typically pre-imaging position AP1 or AP2 and the position at which suction nozzle 80 is imaged after being lifted and lowered is typically post-imaging position BP1 or BP2.

Next, moving device 24 causes mounting head 28 to move above the mounting position of the board. The rotation of Q-axis motor 92 causes the electronic component held by suction nozzle 80 to be modified to a predetermined posture. Nozzle holder 47 of a predetermined mounting head 28 holding the electronic component is lowered and the electronic component is mounted on the board. Positive pressure is supplied to suction nozzle 80 and the electronic component is detached from suction nozzle 80. Subsequently, the predetermined suction nozzle 80 is lifted. The above operations are repeated as appropriate and the electronic component held by suction nozzle 80 is mounted on the board.

In the mounting work, the inspection by side camera 104 is performed. It is confirmed that the electronic component is picked up on the tip end of suction nozzle 80 using the side image in which suction nozzle 80 is imaged at the imaging position before being lifted and lowered. It is confirmed that the electronic component is not picked up on the tip end of suction nozzle 80 using the side image in which suction nozzle 80 is imaged at the imaging position after being lifted and lowered. Incidentally, as in the holding work, the position at which suction nozzle 80 is imaged before being lifted and lowered is typically pre-imaging position AP1 or AP2 and the position at which suction nozzle 80 is imaged after being lifted and lowered is typically post-imaging position BP1 or BP2. In the following description, work from the holding work to the mounting work, which is executed the series described above, is referred to as 1 PP (pick up place) operation.

### Control System Configuration of Electronic Component Mounting Device

Using Fig. 5, a description will be given of the configuration of the control system of mounting machine 16. In addition to the above-described configuration, mounting machine 16 includes control device 140, image processing device 148, mark camera 100, and the like. Control device 140 includes CPU 141, RAM 142, ROM 143, storage section 144, and the like. CPU 141 controls the electrically connected parts by executing various programs stored in ROM 143. Here, the parts are conveyance device 22, moving device 24, mounting head 28, supply device 26, image processing device 148, and the like. RAM 142 is used as the main storage device for CPU 141 to execute various processes. ROM 143 stores a program such as an inspection optimization process (described later), a control program, and various types of data. Storage section 144 is realized using flash memory, for example, and job data 145 and various types of information are recorded thereon.

In addition to the configuration described above, conveyance device 22 includes drive circuit 122 which drives drive circuit 121 and board holding device 48 which drives conveyor motor 46. In addition to the configuration described above, moving device 24 includes drive circuit 125 which drives drive circuit 123 and Y-axis motor 62 which drives X-axis motor 64.

In addition to the configuration described above, mounting head 28 includes drive circuit 126 which drives positive and negative pressure supply device 82, drive circuit 127 which drives R-axis motor 88, drive circuit 128 which drives Q-axis motor 92, drive circuits 129, 129 which drive Z-axis motor 98, and the like. Drive circuit 129 is provided for each Z-axis motor 98, 98. Accordingly, Z-axis driving mechanism 28c is capable of individually lifting and lowering nozzle holders 47.

in addition to the configuration described above, supply device 26 includes drive circuit 131 which drives feed device 76, and the like. Mark camera 100 is fixed to the lower surface of X-axis slider 60 in a state of facing downward and images a fiducial mark for board positioning formed on the board, for example. Image processing device 148 is realized by a computer, for example, and subjects image data captured by mark camera 100, part camera 102, and side camera 104 to image processing. More specifically, the position of the outer shape of, for example, an electronic component included in the image data is digitized and the digitized data is outputted to CPU 141. CPU 141 compares verification data (described later) with the data in which the images are digitized and judges whether the work is being performed as set. As described above, part camera 102 acquires a two-dimensional image in the XY-plane of an electronic component or the like. Side camera 104 acquires a two-dimensional image in the YZ-plane of an electronic component or the like. For example, based on the image obtained by part camera 102, CPU 141 judges whether the position in the XY-plane of the electronic component which is picked up by suction nozzle 80 is within a normal range. Based on the image obtained by side camera 104, for example, CPU 141 judges whether the position in the YZ-plane of the electronic component which is picked up by suction nozzle 80 is within the normal range.

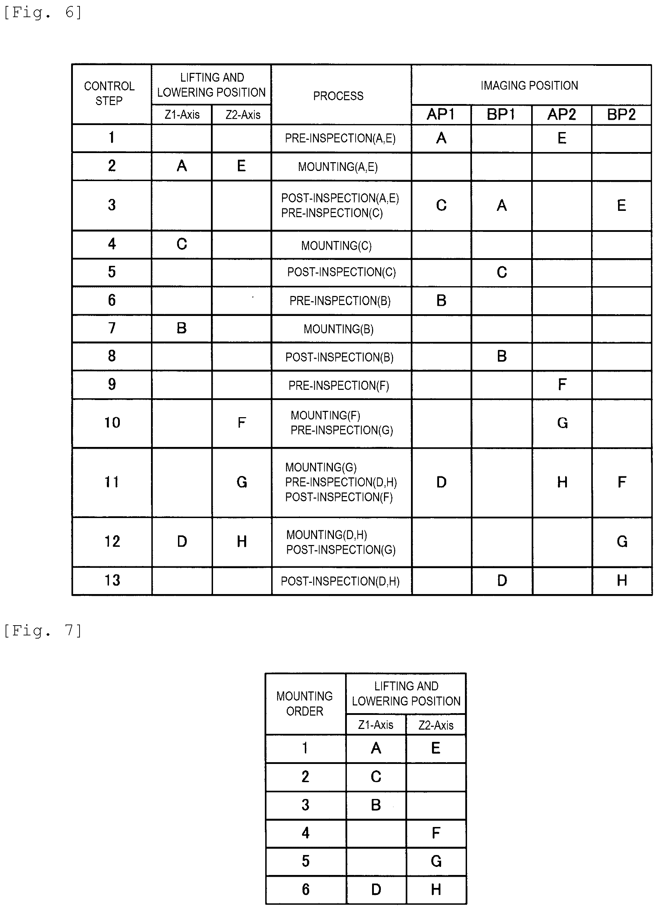

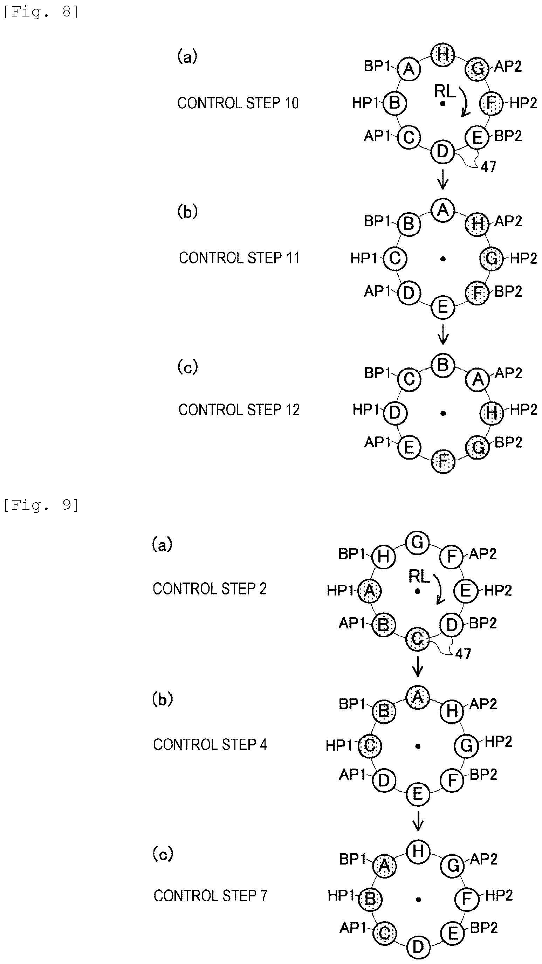

Next, job data 145 will be described. Job data 145 includes sequence data, mounting order data, verification data, and the like. The verification data is data used by mounting device 12 to perform the work as set. For example, the verification data includes data on the position and shape of the electronic components. As exemplified in Fig. 6, the sequence data is data in which the processes performed by control device 140 are arranged in the execution order. The text "control steps" of Fig. 6 is an item indicating the order of the execution procedure. Here, it is assumed that rotary section 84 is regulated to be intermittently rotated one pitch or more every time one step advances. The text "processes" is an item indicating the content of the processes performed in each step. Specifically, there are mounting processes, pre-inspection processes, post-inspection processes, and the like. The pre-inspection processes are processes in which suction nozzle 80 is imaged at the imaging position before the mounting work is performed. The post-inspection process is a process in which suction nozzle 80 is imaged at the imaging position after the mounting work is performed. Here, as illustrated in Fig. 8, it is assumed that the letters A to H are assigned counterclockwise to each nozzle holder 47 as identifiers. As the values of the "processes" of the sequence data, the identifiers of nozzle holders 47 to serve as the targets of each process are indicated in parentheses. The text "lifting and lowering position" is an item indicating, for nozzle holder 47 serving as the target of the mounting work, which of the Z1-axis and the Z2-axis at which the lifting and lowering is to be performed. For example, it is illustrated that, in control step 2, mounting work is performed by nozzle holders 47 of A and E, nozzle holder 47 of A is lifted and lowered in the Z1-axis, nozzle holder 47 of E is lifted and lowered in the Z2-axis. The text "imaging position" is an item indicating, for nozzle holder 47 serving as the target of the pre-inspection process and the post-inspection process, which of the imaging positions at which the lifting and lowering is to be performed. As illustrated in Fig. 7, the mounting order data is data in which the identifiers of nozzle holders 47 serving as targets of the mounting process and the lifting and lowering positions are arranged in the execution order. In the following description, the execution order of the mounting processes is referred to as the mounting order.

In the mounting work, the movement to the mounting position on the board by moving device 24 and the lifting and lowering of nozzle holders 47 for mounting are repeatedly performed. Here, it is assumed that the sequence data is optimized such that, for example, the movement distance of moving device 24 is shortest. Therefore, in some cases, the order of nozzle holders 47 in which mounting work is performed is not the arrangement order according to the rotation direction in rotary section 84, that is, is not alphabetical order. Nozzle holder 47 in which the lifting and lowering position is the Z1-axis is configured such that the pre-imaging process is performed at pre-imaging position AP1 and the post-imaging process is performed at the post-imaging position BP1. Similarly, nozzle holder 47 in which the lifting and lowering position is the Z2-axis is configured such that the pre-imaging process is performed at pre-imaging position AP2 and the post-imaging process is performed at post-imaging position BP2.

When the mounting order is the arrangement order as in control steps 10 to 12 of Fig. 6, it is possible to perform the n-th mounting process, the (n - 1)-th post-inspection process, and the (n + 1)-th pre-inspection process in the same control step. A description will be given using Fig. 8. In control steps 10 to 12, the mounting work of nozzle holders 47 of F, G, and H, respectively, is performed at lifting and lowering position HP2. Nozzle holders 47 of F, G, and H are in the arrangement order of rotary section 84. Therefore, as illustrated in Fig. 8 (b), when nozzle holder 47 of G is at lifting and lowering position HP2 in control step 11, nozzle holder 47 of F is positioned at post-imaging position BP2 and nozzle holder 47 of H is positioned at pre-imaging position AP2. Therefore, it is possible to perform the mounting process of nozzle holder 47 of G, the post-imaging process of nozzle holder 47 of F, and the pre-imaging process of nozzle holder 47 of H in the same control step.

On the other hand, as in control steps 2 to 7 of Fig. 6, when the mounting order is not the arrangement order, the n-th mounting process, the (n - 1)-th post-inspection process, and the (n + 1)-th pre-inspection process may not be performed in the same control step. A description will be given using Fig. 9. In control steps 2 to 7, the mounting work of nozzle holders 47 of A, C, and B is performed at lifting and lowering position HP1. Nozzle holders 47 of A, C, and B are not in the arrangement order of rotary section 84. Therefore, as illustrated in Fig. 9 (b), when nozzle holder 47 of C in control step 4 is at lifting and lowering position HP1, nozzle holder 47 of A is not positioned at any of post-imaging position BP1 or BP2 and nozzle holder 47 of B is not positioned at either pre-imaging position AP1 or AP2. In job data 145, nozzle holder 47 in which the lifting and lowering position is the Z1-axis is subjected to the pre-imaging process at pre-imaging position AP1 and is subjected to the post-imaging process at post-imaging position BP1. Therefore, the mounting process of nozzle holder 47 of C, the post-imaging process of nozzle holder 47 of A, and the pre-imaging process of nozzle holder 47 of B may not be performed in the same control step. Therefore, as illustrated in Fig. 6, in control step 3 before control step 4 in which the lifting and lowering process of nozzle holder 47 of C is performed, the post-imaging process of nozzle holder 47 of A is performed and in control step 6 after control step 4, the pre-imaging process of nozzle holder 47 of B is performed. In order to reduce the number of control steps in job data 145 created in this manner, an inspection optimization process described below is executed.

### Inspection Optimization Process

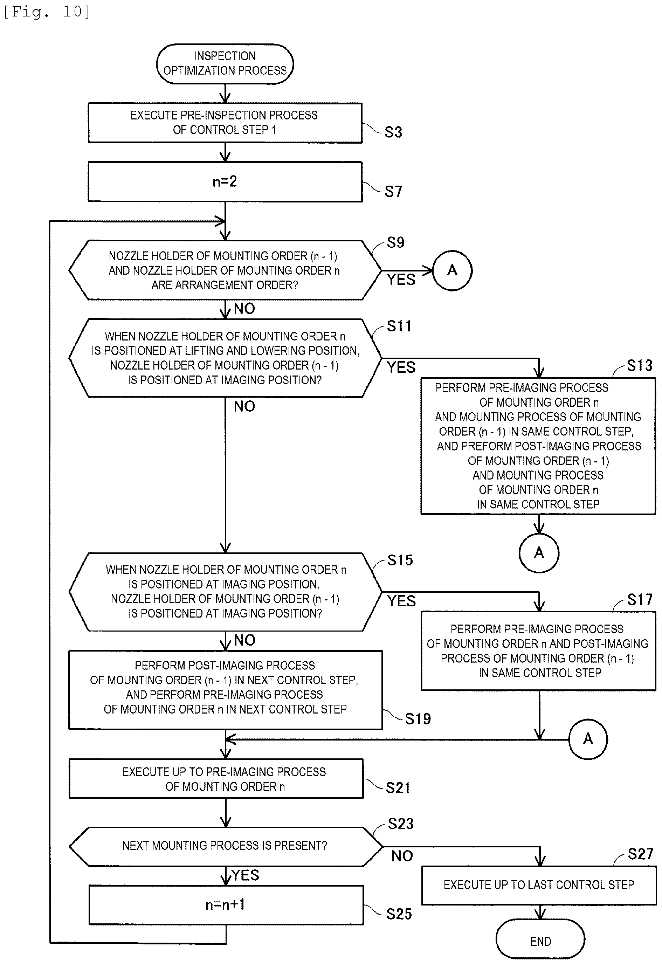

The inspection optimization process illustrated in Fig. 10 will be described by exemplifying the case of the sequence data illustrated in Fig. 6 as appropriate. When CPU 141 receives the start of the mounting work, CPU 141 reads job data 145 and executes the inspection optimization process for each 1 PP operation. First, CPU 141 executes the pre-inspection process of the first control step of the sequence data (S3). Specifically, according to job data 145, rotary section 84 is caused to pivot such that nozzle holder 47 serving as the target of the pre-inspection process is positioned at the imaging position set by the sequence data and side camera 104 is caused to perform imaging. Next, variable n, which is the variable used in the inspection optimization process, is set to 2 (S7). Next, the mounting order data is referred to and it is judged whether nozzle holder 47 of which the mounting order is n and nozzle holder 47 of which the mounting order is (n-1) are the arrangement order (S9). For example, when nozzle holder 47 of which the mounting order is 1 is A and nozzle holder 47 of which the mounting order is 2 is B, it is judged to be the arrangement order. When the arrangement order is judged positively (S9: YES), the process proceeds to step S21 in order to perform the pre-imaging process and the post-imaging process in accordance with job data 145.

On the other hand, when the arrangement order is not judged positively (S9: NO), CPU 141 refers to job data 145, and when nozzle holder 47 of which the mounting order is n is positioned at the set lifting and lowering position, judges whether nozzle holder 47 of which the mounting order is (n - 1) is positioned at any of the imaging positions (S11). For example, in a case in which variable n is 3, when nozzle holder 47 of B in which the mounting order is 3 is positioned at the set lifting and lowering position HP1, it is judged whether nozzle holder 47 of C in which the mounting order is 2 is positioned at any of the imaging positions. In this case, as illustrated in Fig. 9 (c), when nozzle holder 47 of B is positioned at the set lifting and lowering position HP1, since nozzle holder 47 of C in which the mounting order is 2 is positioned at pre-imaging position AP1, it is judged to be YES. In contrast, for example, when variable n is 2, as illustrated in Fig. 9 (b), when nozzle holder 47 of C in which the mounting order is 2 is positioned at lifting and lowering position HP1, since nozzle holders 47 of A and E in which the mounting order is 1 are not positioned at any of the imaging positions, step S11 is judged to be NO. When the position is judged positively (S11: YES), it is determined that the pre-imaging process of nozzle holder 47 of which the mounting order is n is performed in the control step of performing the mounting work in which the mounting order is (n - 1), it is determined that the post-imaging process of nozzle holder 47 of which the mounting order is (n - 1) is performed in the control step of performing the mounting work in which the mounting order is n, and the determined content is stored in RAM 142 (S13). After the execution of step S13, the process proceeds to step S21.

On the other hand, when the position is not judged positively (S11: NO), CPU 141 refers to job data 145, and when nozzle holder 47 of which the mounting order is n is positioned at the imaging position, it is judged whether nozzle holder 47 of which the mounting order is (n-1) is at the imaging position (S15). For example, as illustrated in Fig. 8 (a), since nozzle holder 47 of C in which the mounting order is 2 and nozzle holders 47 of A and E in which the mounting order is 1 are in a positional relationship capable of being imaged at the same time, it is judged to be YES. Incidentally, since the relative position of the four imaging positions does not change, nozzle holders 47 positioned at cross positions centered on R-axis line RL are positioned at the imaging positions at the same time as each other. Describing in detail with reference to Figs. 8 (a) and (b), nozzle holders 47 of A, C, E, and G are positioned at the imaging positions at the same time as illustrated in Fig. 8 (a) and nozzle holders 47 of B, D, F, and H are positioned at the imaging positions at the same time as illustrated in Fig. 8 (b). When the position is judged positively (S15: YES), in the control step one before the control step of performing the mounting work in which the mounting order is n, it is determined that the post-imaging process of nozzle holder 47 of which the mounting order is (n -1) and the pre-imaging process of nozzle holder 47 of which the mounting order is n are performed, and the determined content is stored in RAM 142 (S17). After the execution of step S17, the process proceeds to step S21.

On the other hand, in step S15, when the position is not judged positively (S15: NO), CPU 141 determines that the post-imaging process of nozzle holder 47 of which the mounting order is (n-1) will be performed in the control step two before the control step of performing the mounting work in which the mounting order is n and that the pre-imaging process of nozzle holder 47 of which the mounting order is n will be performed in the control step one before the control step of performing the mounting work in which the mounting order is n, and stores the determined content in RAM 142 (S19). After the execution of step S19, the process proceeds to step S21. In the case of a configuration in which the number of nozzle holders 47 is eight, since the judgment is YES is always made one of the steps S9, S11, and S15, the process of the step S21 is not executed. In other words, in the case of a configuration in which there are more than eight nozzle holders 47, step S19 is executed.

In step S21, CPU 141 executes the control steps including the pre-imaging process in the mounting order n according to job data 145 and the determined content stored in RAM 142. The processes to be executed differs depending on the determined content. For example, when the step S17 or the step S19 is executed, at least the lifting and lowering process and the post-imaging process of the mounting order (n - 1) and the pre-imaging process of the mounting order n are performed. When step S9 is judged to be YES and when step S13 is executed, at least the lifting and lowering process of the mounting order (n - 1) and the pre-imaging process of the mounting order n are performed. Here, "at least" is denoted because the post-imaging process of the mounting order (n-2) may be executed in step S21.

Next, referring to the mounting order data, it is judged whether there is a subsequent mounting process (S23). When is judged that there is a subsequent mounting process (S23: YES), variable n is incremented by 1 (S25) and the process returns to step S9. On the other hand, when it is judged that there is no subsequent mounting process (S23: NO), the processes up to the last control step are executed and the inspection optimization process is ended.

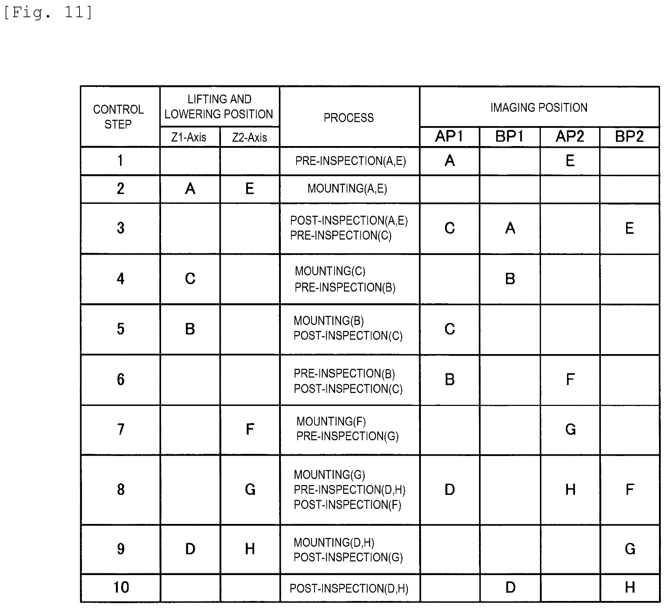

Fig. 11 illustrates the content of the control steps to be executed when the inspection optimization process is performed. Compared to Fig. 6, the number of control steps is reduced by three. For example, mounting order 1 to 3 of the mounting order data are not the arrangement order. Here, by executing the inspection optimization process, in control step 4 in which the mounting process of nozzle holder 47 of C is included, it is assumed that the pre-inspection process of nozzle holder 47 of B will be performed. In control step 5 in which the mounting process of nozzle holder 47 of B is included, the post-inspection process of nozzle holder 47 of C is to be performed. In control step 6, the post-inspection process of nozzle holder 47 of B and the pre-inspection process of nozzle holder 47 of F are to be performed. Accordingly, the number of control steps is reduced.

In the embodiment, mounting head 28 is an example of a rotary head, Z-axis driving mechanism 28c is an example of a lifting and lowering section, side camera 104 is an example of an imaging section, and CPU 141 is an example of a control section. Step S11 is an example of the first determination process, step S13 is an example of a first judgment process, step S15 is an example of a second judgment process, step S17 is an example of a second determination process, and step S19 is an example of a third determination process. The mounting order is an example of a lifting and lowering order.

According to the first embodiment described above, the following effects are obtained. In the inspection optimization process, in a case in which nozzle holder 47 of which the mounting order is n is positioned at set lifting and lowering positions HP1 and HP2, when nozzle holder 47 of which the mounting order is (n - 1) is judged to be positioned at any of the imaging positions (S11: YES), it is determined that the pre-imaging process of nozzle holder 47 of which the mounting order is n is to be performed in the control step of performing the mounting work in which the mounting order is (n - 1), and it is determined that the post-imaging process of nozzle holder 47 of which the mounting order is (n - 1) is to be performed in the control step of performing the mounting work in which the mounting order is n. Thereafter, in step S21, the pre-imaging process of nozzle holder 47 of which the mounting order is n is performed in the control step of performing the mounting work in which the mounting order is (n-1) and the post-imaging process of nozzle holder 47 of which the mounting order is (n-1) is performed in the control step of performing the mounting work in which the mounting order is n. Accordingly, due to the pre-imaging process or the post-imaging process and the control step in which the lifting and lowering process being executed in the same step, the number of control steps is reduced as compared to providing a control step for only the pre-imaging process or the post-imaging process, thereby it becomes possible to efficiently execute the process.

When the judgment is YES in step S11 in the inspection optimization process, the post-imaging process of the mounting order is (n - 1) is performed and the mounting process of the mounting order is n in the same control step. When the judgment is YES in the step S15, the post-imaging process of the mounting order (n - 1) is performed together with the pre-imaging process of the mounting order n in a control step after the mounting process of the mounting order (n - 1). When the judgment is NO in the step S15, the post-imaging process of the mounting order (n - 1) is performed in the control step after the mounting process of the mounting order (n - 1). Since it is possible to perform the post-imaging process of the mounting order (n - 1) in the control step after the control step in which the lifting and lowering process of the mounting order (n - 1) is performed, it is possible to perform the post-imaging process early. Accordingly, in a case in which it is confirmed by the post-imaging process that the work is not performed in a normal manner, it is possible to perform work for handling this case such as performing the work again, for example.

### Second Embodiment

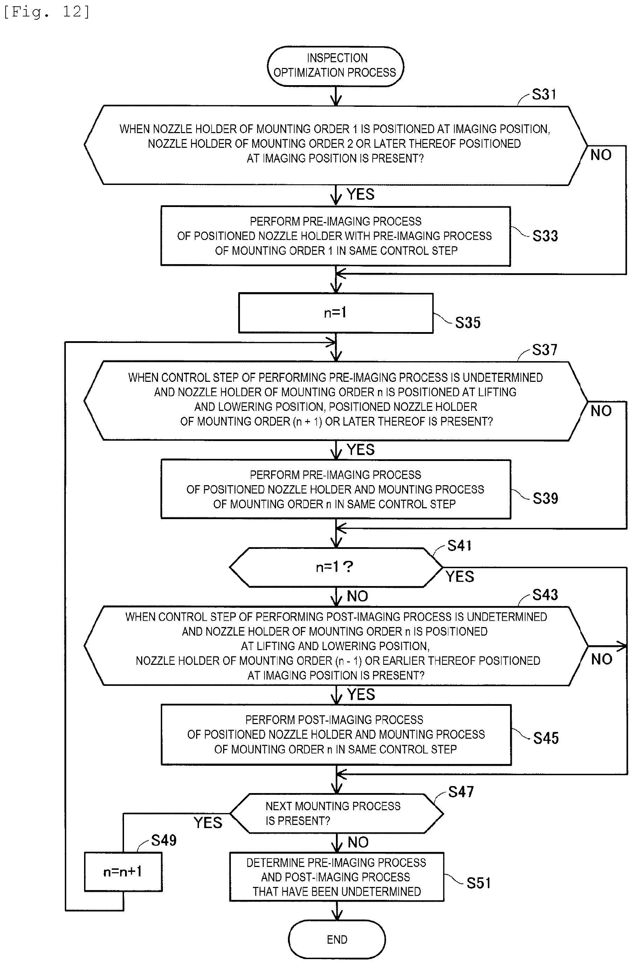

Next, an inspection optimization process according to the second embodiment will be described. The inspection optimization process according to the second embodiment is executed before the start of the mounting work and the mounting work is performed after the execution of the inspection optimization process. When receiving the start of the mounting work, CPU 141 reads job data 145 and executes the inspection optimization process indicated in Fig. 12 with 1 PP operation as the target.

First, when nozzle holder 47 of which the mounting order is 1 is positioned at the imaging position set in the sequence data, CPU 141 judges whether nozzle holder 47, in which the mounting order is 2 or later, positioned at the imaging position is present (S31). When it is judged to be present (S31: Yes), it is determined that the pre-imaging process of nozzle holder 47, being positioned at the imaging position, and the control step of performing the pre-imaging process, in which the mounting order is 1, are performed in the same control step, and the determined content is stored in RAM 142 (S33), and the process proceeds to step S35. On the other hand, when it is judged to not be present (S31: NO), step S33 is skipped, and the process proceeds to step S35. Variable n is set to 1 (S35).

Next, CPU 141 judges whether nozzle holder 47, in which the mounting order is (n + 1) or later positioned at the imaging position when the control step for performing the pre-imaging process is undetermined and nozzle holder 47 of which the mounting order is n is positioned at the lifting and lowering position set by the sequence data, is present (S37). When it is judged to be positioned (S37: Yes), it is determined that the pre-imaging process of nozzle holder 47, being positioned at the imaging position, and the control step of performing the mounting process, in which the mounting order is n, are performed in the same control step, and the determined content is stored in RAM 142 (S39), and the process proceeds to step S41. On the other hand, when it is judged to not be positioned (S37: NO), step S39 is skipped, and the process proceeds to step S41.

Next, CPU 141 judges whether variable n is 1 (S41). When it is judged to be 1 (S41: Yes), since there is no post-imaging process to be examined, steps S43 and S45 are skipped, and the process proceeds to step S47. On the other hand, when it is judged not to be 1 (S41: No), in order to examine the post-imaging process nozzle holder 47 of which the mounting order is (n-1) or earlier, it is judged whether nozzle holder 47, in which the mounting order is (n-1) or earlier positioned at the imaging position when the control step for performing the post-imaging process is undetermined and nozzle holder 47 of which the mounting order is n is positioned at the lifting and lowering position set by the sequence data, is present (S43). When it is judged to be present (S43: Yes), it is determined that the post-imaging process of nozzle holder 47, being positioned at the imaging position, and the control step of performing the mounting process, in which the mounting order is n, are performed in the same control step, and the determined content is stored in RAM 142 (S45), and the process proceeds to step S47. On the other hand, when it is judged to not be present (S43: No), step S45 is skipped, and the process proceeds to step S47. Next, in the same manner as in step S23, it is judged whether there is a subsequent mounting process (S47). When is judged that there is a mounting process (S47: Yes), variable n is incremented by 1 (S49) and the process returns to step S37. On the other hand, when it is judged that there is not to be a mounting process (S47: No), in a case in which nozzle holder 47 for which the control step of performing the pre-imaging process or the post-imaging process is undetermined is present, the control step of performing the pre-imaging process or the post-imaging process is determined and stored in RAM 142 (S51). Specifically, it is determined that the undetermined pre-imaging process in which the mounting order is n is to be performed in the control step one before the mounting process in which the mounting order is n and that the undetermined post-imaging process in which the mounting order is n is to be performed in the control step one after the mounting process in which the mounting order is n. After the execution of step S51, the inspection optimization process is ended. Thereafter, the mounting work is performed in accordance with the determined content.

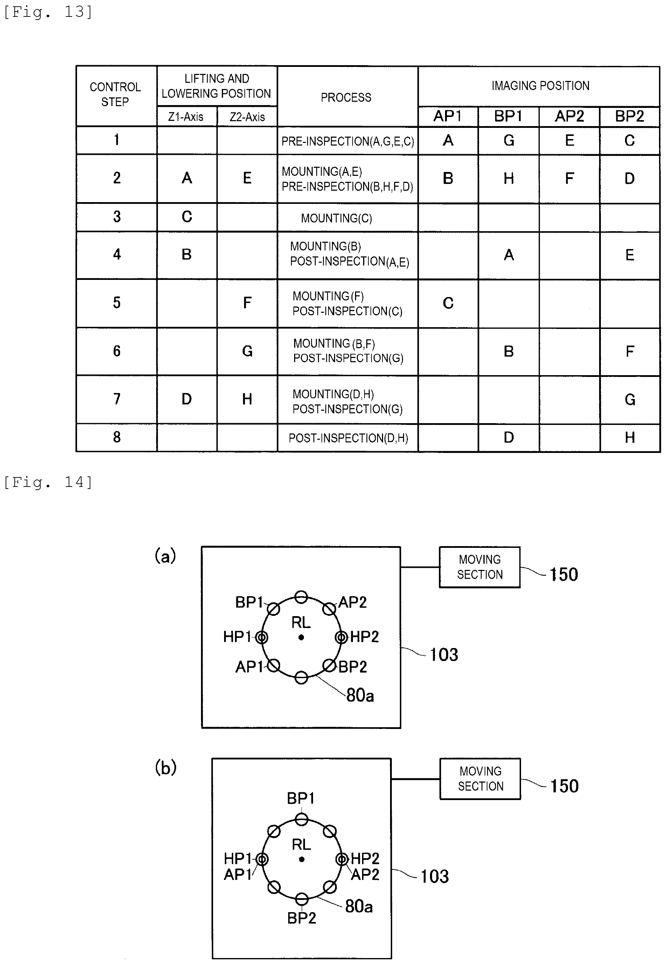

Fig. 13 illustrates the sequence data after the inspection optimization process is executed. Compared to Fig. 6, the number of control steps is reduced by five. Due to the inspection optimization process being executed, the content of the sequence data is changed such that the pre-inspection process or the post-inspection process is included in control step 1 including the pre-inspection process in which the mounting order is 1 and the control step including the mounting process in which the mounting order is 2 or later. Accordingly, it is possible to reduce the number of control steps.

According to the second embodiment described above, the following effects are obtained. In the inspection optimization process, when nozzle holder 47 of which the mounting order is n is positioned at the lifting and lowering position set by job data 145 and when it is judged that nozzle holder 47 of which the mounting order is (n + 1) or later is positioned at the imaging position (S37: Yes), it is determined that the pre-imaging process of nozzle holder 47, being positioned at the imaging position, and the control step of performing the mounting process, in which the mounting order is n, are performed in the same control step (S39). When it is judged that nozzle holder 47 of which the mounting order is (n - 1) or earlier is positioned at the imaging position when nozzle holder 47 of which the mounting order is n is positioned at the lifting and lowering position set by job data 145 (S43: Yes), it is determined that the post-imaging process of nozzle holder 47, being positioned at the imaging position, and the control step of performing the mounting process in which the mounting order is n are performed in the same control step (S45). When the nozzle holder serving as the target of the lifting and lowering process is at the lifting and lowering position, since it is possible to perform the pre-inspection process or post-inspection process for nozzle holder 47 at the imaging position, it is possible to efficiently reduce the number of control steps.

### Third Embodiment

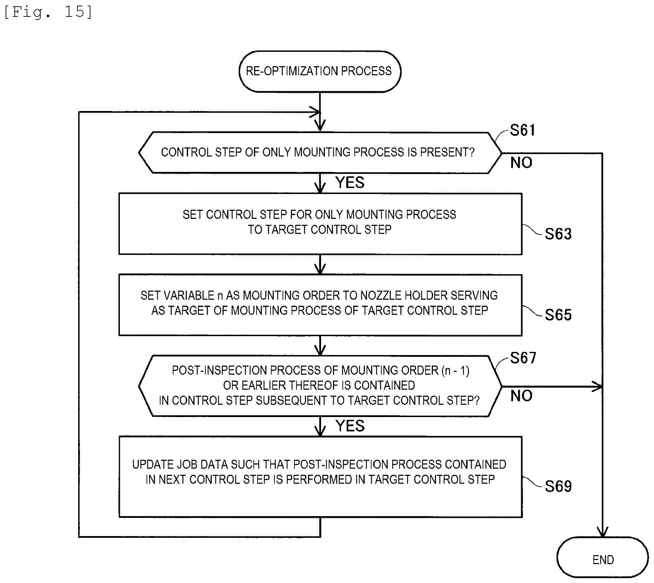

The mounting device according to the third embodiment includes, as illustrates in Figs. 14 (a) and (b), moving section 150 for moving imaging section 103 such that pre-imaging positions AP1 and AP2 and post-imaging positions BP1 and BP2 move relative to lifting and lowering positions HP1 and HP2. Specifically, moving section 150 causes imaging section 103 to move relative to mounting head 28 while maintaining the relative position between imaging positions to be a position of one of the position illustrated in Fig. 14 (a) which is the same position as in the first embodiment illustrated in Fig. 4 and a position at which lifting and lowering position HP1 and pre-imaging position AP1 overlap as illustrated in Fig. 14 (b). In the following description, the position of imaging section 103 illustrated in Fig. 14 (a) will be referred to as position a and the position of imaging section 103 illustrated in Fig. 14 (b) will be referred to as position b. In the third embodiment, after the inspection optimization process according to the second embodiment is executed, a re-optimization process illustrated in Fig. 15 is executed on the updated job data 145.

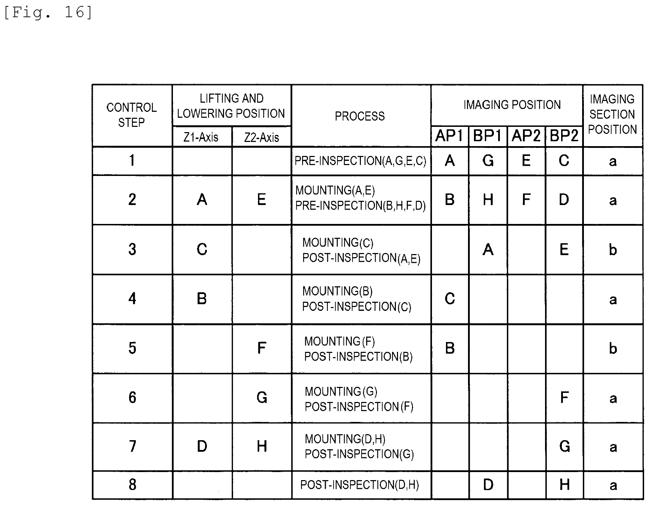

When the inspection optimization process according to the second embodiment is ended, CPU 141 executes the re-optimization process illustrated in Fig. 15 with the sequence data of the latest job data 145 as the target. First, Fig. 16 illustrates the modified sequence data after the re-optimization process is executed. In the sequence data illustrated in Fig. 16, an item of "imaging section position" is added to the sequence data illustrated in Fig. 13. The "imaging section position" is an item for inputting which of position a and position b is the position of imaging section 103.

First, CPU 141 adds the item "imaging section position" to the sequence data and sets the "imaging section position" to "a" for all of the control steps. Next, it is judged whether there is a control step of only the mounting process (S61). For example, in the sequence data illustrated in Fig. 13, since control step 3 is a step of only the mounting process, step S61 is judged to be Yes. When it is judged that there is a control step of only the mounting process (S61: Yes), the control step of only the mounting process is set as the target control step (S63) and variable n is set to the mounting order of nozzle holder 47 serving as the target of the mounting work to be performed in the target control step (S65). For example, since the mounting order of nozzle holder 47 in which the mounting work of control step 3 is performed is 2, variable n is set to 2. Next, it is judged whether the post-inspection process in which the mounting order is (n - 1) or earlier is included in the control step after the target control step (S67). When it is judged that the post-inspection process in which the mounting order is (n - 1) or earlier is included (S67: Yes), it is determined that the post-inspection process judged to be included is to be performed in the target control step, assuming that the position of imaging section 103 is one of positions a and b at which it is possible to execute the pre-imaging process or the post-imaging process, and the sequence data is updated (S69).

For example, when control step 3 of the sequence data illustrated in Fig. 13 is the target control step, the post-inspection process in which the mounting order is 1 or earlier is included in control step 4. Specifically, since the post-inspection process of nozzle holders 47 of A and E in which the mounting order is 1 is included, it is determined to perform the post-inspection process of nozzle holders 47 of A and E in control step 3. Here, by setting the position of imaging section 103 to position b, it becomes possible for the mounting process of nozzle holder 47 of C and the post-inspection process of nozzle holders 47 of A and E to be performed in the same control step (refer to Fig. 8 (b)). Returning to Fig. 15, after executing step S69, CPU 141 returns to step S61. On the other hand, when No is judged in steps S61 and S67, the re-optimization process is terminated.

In a case in which control step 3 of the sequence data illustrated in Fig. 13 is the target control step, when nozzle holders 47 of A and E included in control step 4 of the sequence data illustrated in Fig. 13 are to be performed in control step 3, control step 4 of the sequence data illustrated in Fig. 13 becomes a control step of only the mounting process. In this manner, the control step of only the mounting process changes in accordance with the execution of step S69. Therefore, the processes of step S63 onward are performed until there are no control steps of only the mounting process. When comparing the sequence data after the inspection optimization process is executed (Fig. 16) and Fig. 13, although the number of control steps is the same, the execution timing of the post-imaging process of nozzle holders 47 of A, E, C, and B is sooner. In Fig. 13, the post-imaging process of any of A, E, C, and B is included in the control step two after the control step in which the mounting process is performed, but in Fig. 16, the post-imaging process is included in the control step one after the control step in which the mounting process is performed. In this manner, it is possible to obtain the sequence data in which it is possible to perform the post-imaging process early by executing the re-optimization process.

According to the third embodiment described above, the following effects are obtained. In the inspection re-optimization process, when it is judged that the control step of only the mounting process is present (S61: Yes) and when it is judged that the post-inspection process in which the mounting order is (n - 1) or earlier is included (S67: Yes), it is determined that the post-inspection process in which the mounting order is (n - 1) is to be performed in the target control step, assuming that the position of imaging section 103 is one of positions a and b at which it is possible to execute the pre-imaging process or the post-imaging process. Accordingly, it is possible to perform the post-imaging process early in the control step after the lifting and lowering process.

The present invention is not to be limited to the embodiments and it goes without saying that various improvements and changes can be made within the limits of the appended claims. For example, although mounting head 28 including eight nozzle holders 47 is exemplified above, the number of nozzle holders 47 is not limited.

In the above description, an example in which the inspection optimization process is applied to the mounting work has been described. That is, although the mounting order is exemplified as the lifting and lowering order, the application is not limited to the mounting work. For example, it is also possible to apply the present invention to work of holding an electronic component supplied from supply device 26, work of dipping an electronic component for surface mounting in solder, or the like.

In the above description, moving section 150 has been described as moving imaging section 103 relative to the lifting and lowering positions HP1 and HP2, but is not limited thereto. For example, a configuration may be adopted in which, within imaging section 103, the position of side camera 104 is fixed and the positions of the components for changing the light paths such as first mirror 107, first prism 109, and the like are changed. A configuration may be adopted in which the positions of the components for changing the light paths are changed, for example, such that the positions of pre-imaging positions AP1 and AP2 and post-imaging positions BP1 and BP2 are changed independently of each other.

In the second embodiment, a description is given of the mounting work being performed after the execution of the inspection optimization process, but the execution timing of the inspection optimization process is not limited thereto. For example, a configuration may be adopted in which the inspection optimization process and the mounting work are executed in parallel, such as executing control step 1 at a timing when the process content of control step 1 is determined. Alternatively, a configuration may be adopted in which job data 145 is modified in accordance with the determined content after the inspection optimization process is executed and the mounting work is performed in accordance with the modified job data 145.

In the above description, although a configuration has been described in which there are two lifting and lowering positions, it is also possible to apply the present technology a configuration in which there is one lifting and lowering position. The greater the number of lifting and lowering positions, in conjunction with this, since the number of the pre-imaging positions and post-imaging positions is also increased, the number of pre-imaging processes and post-imaging processes which it is possible to perform in one control step also increases. Therefore, since the greater the number of lifting and lowering positions, the greater the possibility of reducing the number of control steps, the advantages of the present technology are more easily obtained.

### Reference Signs List

12 Electronic component mounting device, 47 nozzle holder, 28 mounting head, 80 suction nozzle, 28c Z-axis driving mechanism, 103 imaging section, 104 side camera, 141 CPU

## Claims

1. An electronic component mounting device (12) comprising:
a rotary head, in which multiple nozzle holders (47) are disposed on a circumference centered on an axis, and which is configured to pivot about the axis;
a suction nozzle (80), being held by the nozzle holder (47), which is configured to pick up a component;
a lifting and lowering section configured to lift and lower the nozzle holder (47) at a lifting and lowering position on the circumference for picking up or mounting the component with the suction nozzle (80);
an imaging section (103) configured to image the suction nozzle (80) at a pre-imaging position and a post-imaging position on the circumference of the lifting and lowering position; and
a control section configured to perform control based on job data in which an order of control steps is predetermined, wherein
the control steps include at least one of a lifting and lowering process executed with the lifting and lowering section,
a pre-imaging process in which the suction nozzle (80) is imaged by the imaging section (103) at the pre-imaging position or the post-imaging position before execution of the lifting and lowering process, and
a post-imaging process in which the suction nozzle (80) is imaged by the imaging section (103) at the pre-imaging position or the post-imaging position after execution of the lifting and lowering process,
**characterized in that**
in a case where a lifting and lowering order which is an order of the nozzle holder (47) serving as a target of the lifting and lowering process in the job data is not an arrangement order on the circumference, the control section is configured to execute the post-imaging process targeting the nozzle holder (47) and the lifting and lowering process of the n-th nozzle holder (47) of which the lifting and lowering order is n, in the same control step, in a case where the nozzle holder (47) of which the lifting and lowering order is n-1 or earlier than the n-th is positioned at the pre-imaging position or the post-imaging position, when the nth nozzle holder (47) in the lifting and lowering order is positioned at the lifting and lowering position, and
the control section is configured to execute the pre-imaging process targeting the nozzle holder (47) and the lifting and lowering process of the n-th nozzle holder (47) in the same control step, in a case where the nozzle holder (47) of which the lifting and lowering order of the nozzle holder (47) is later than the n-th is positioned at the pre-imaging position or the post-imaging position, when the n-th nozzle holder (47) in the lifting and lowering order is positioned at the lifting and lowering position, wherein the pre-imaging position (AP1, AP2) is a stopping position one pitch before the lifting and lowering position (HP1, HP2), and the post-imaging position (BP1, BP2) is a stopping position one pitch after the lifting and lowering position (HP1, HP2).

2. The electronic component mounting device (12) according to claim 1, wherein
there are multiple lifting and lowering positions,
the lifting and lowering section is configured to individually lift and lower the nozzle holder (47) at the multiple lifting and lowering positions, and
the imaging section (103) is configured to image the suction nozzle (80) at the pre-imaging position and the post-imaging position of each of the multiple lifting and lowering positions.

3. The electronic component mounting device (12) according to claim 1 or 2, further comprising:
a moving section configured to move the imaging section (103) such that the preimaging position and the post-imaging position move relative to the lifting and lowering position, wherein
when neither of the pre-imaging process and the post-imaging process is included in the control step including the lifting and lowering process, the control section is configured to control the moving section such that the pre-imaging position or the postimaging position is positioned at a position of the nozzle holder (47) serving as a target of the pre-imaging process or the post-imaging process included in the control step after the relevant control step.

4. The electronic component mounting device (12) according to claim 1 or 2, wherein
the control section is configured to execute a first judgment process of judging whether the (n - 1)-th nozzle holder (47) is positioned or not at the pre-imaging position or the post-imaging position when the n-th nozzle holder (47) is positioned at the lifting and lowering position,
a first determination process of determining that the post-imaging process of the (n - 1)-th nozzle holder (47) is to be executed in the control step in which the lifting and lowering process of the n-th nozzle holder (47) is executed when the (n - 1)-th nozzle holder (47) is judged to be positioned in the first judgment process,
a second judgment process of judging whether the n-th nozzle holder (47) is positioned or not at the pre-imaging position or the post-imaging position when the (n - 1)-th nozzle holder (47) is positioned at the pre-imaging position or the postimaging position when the (n - 1)-th nozzle holder (47) is judged not to be positioned in the first judgment process,
a second determination process of determining that the post-imaging process of the (n - 1)-th nozzle holder (47) and the pre-imaging process of the n-th nozzle holder (47) are to be executed in the control step after the control step in which the lifting and lowering process of the (n - 1)-th nozzle holder (47) is executed when the n-th nozzle holder (47) is judged to be positioned in the second judgment process, and
a third determination process of determining that the post-imaging process of the (n - 1)-th nozzle holder (47) is to be performed in the control step after the control step in which the lifting and lowering process of the (n - 1)-th nozzle holder (47) is executed when the n-th nozzle holder (47) is judged not to be positioned in the second judgment process.

5. A control method of an electronic component mounting device (12), wherein
the electronic component mounting device (12) is provided with a rotary head, in which multiple nozzle holders (47) are disposed on a circumference centered on an axis, and which is configured to pivot about the axis, a suction nozzle (80), being held by the nozzle holder(47) , which is configured to pick up a component, a lifting and lowering section configured to lift and lower the nozzle holder (47) at a lifting and lowering position on the circumference, an imaging section (103) configured to image the suction nozzle (80) at a pre-imaging position and a post-imaging position on the circumference of the lifting and lowering position, and a control section configured to perform control according to job data in which an order of control steps is predetermined, and
the control steps include at least one of:
a lifting and lowering process by the lifting and lowering section, a pre-imaging process in which the suction nozzle (80) is imaged by the imaging section (103) at the pre-imaging position or the post-imaging position before execution of the lifting and lowering process, and a post-imaging process in which the suction nozzle (80) is imaged by the imaging section (103) at the pre-imaging position or the post-imaging position after execution of the lifting and lowering process, and
**characterized by**
the control method comprising:
in a case where a lifting and lowering order which is an order of the nozzle holder (47) serving as a target of the lifting and lowering process in the job data is not an arrangement order on the circumference,
executing the post-imaging process targeting the nozzle holder (47) and the lifting and lowering process of the n-th nozzle holder (47) of which the lifting and lowering order is n, in the same control step, in a case where the nozzle holder (47) of which the lifting and lowering order is n-1 or earlier than the n-th is positioned at the pre-imaging position or the post-imaging position, when the n-th nozzle holder (47) in the lifting and lowering order is positioned at the lifting and lowering position, and
executing the pre-imaging process targeting the nozzle holder (47) and the lifting and
lowering process of the n-th nozzle holder (47) in the same control step, in a case where the nozzle holder (47) of which the lifting and lowering order of the nozzle holder (47) is later than the n-th is positioned at the pre-imaging position or the post-imaging position, when the n-th nozzle holder (47) in the lifting and lowering order is positioned at the lifting and lowering position, wherein the pre-imaging position (AP1, AP2) is a stopping position one pitch before the lifting and lowering position (HP1, HP2), and the post-imaging position (BP1, BP2) is a stopping position one pitch after the lifting and lowering position (HP1, HP2).

## Patentansprüche

1. Vorrichtung (12) zur Montage von elektronischen Bauteilen umfassend:
einen Drehkopf, in dem mehrere Düsenhalter (47) an einem Umfang angeordnet sind, der auf einer Achse zentriert ist, und der so konfiguriert ist, dass er um die Achse schwenkt;
eine Saugdüse (80), die von dem Düsenhalter (47) gehalten wird und die so konfiguriert ist, dass sie ein Bauteil aufnimmt;
einen Hebe- und Senkabschnitt, der so konfiguriert ist, dass er den Düsenhalter (47) in einer Hebe- und Senkposition auf dem Umfang hebt und senkt, um das Bauteil mit der Saugdüse (80) aufzunehmen oder zu montieren;
einen Abbildungsabschnitt (103), der so konfiguriert ist, dass er die Saugdüse (80) in einer Vorabbildungsposition und einer Nachabbildungsposition auf dem Umfang der Hebe- und Senkposition abbildet; und
ein Steuergerät, das so konfiguriert ist, dass es eine Steuerung auf der Grundlage von Auftragsdaten durchführt, in denen eine Reihenfolge von Steuerschritten vorgegeben ist, wobei
die Steuerschritte mindestens einen von einem Hebe- und Senkprozess umfassen, der mit dem Hebe- und Senkabschnitt ausgeführt wird,
einen Vorabbildungsprozess, bei dem die Saugdüse (80) durch den Abbildungsabschnitt (103) an der Vorabbildungsposition oder der Nachabbildungsposition vor der Ausführung des Hebe- und Senkprozesses abgebildet wird, und
einen Nachabbildungsprozess, bei dem die Saugdüse (80) durch den Abbildungsabschnitt (103) an der Vorabbildungsposition oder der Nachabbildungsposition nach Ausführung des Hebe- und Senkprozesses abgebildet wird,
**dadurch gekennzeichnet, dass**
in einem Fall, in dem eine Hebe- und Senkreihenfolge, die eine Reihenfolge des Düsenhalters (47) ist, der als ein Ziel des Hebe- und Senkprozesses in den Auftragsdaten dient, keine Anordnungsreihenfolge auf dem Umfang ist, das Steuergerät konfiguriert ist, um den Nachabbildungsprozess, der auf den Düsenhalter (47) zielt, und den Hebe- und Senkprozess des n-ten Düsenhalters (47), dessen Hebe- und Senkreihenfolge n ist, durchzuführen, in demselben Steuerschritt in einem Fall, in dem der Düsenhalter (47), dessen Hebe- und Senkreihenfolge n-1 oder früher als der n-te ist, an der Vorabbildungsposition oder der Nachabbildungsposition positioniert ist, wenn der n-te Düsenhalter (47) in der Hebe- und Senkreihenfolge an der Hebe- und Senkposition positioniert ist, und
das Steuergerät so konfiguriert ist, dass es den auf den Düsenhalter (47) gerichteten Vorabbildungsprozess und den Hebe- und Senkprozess des n-ten Düsenhalters (47) in demselben Steuerschritt ausführt, wenn der Düsenhalter (47), dessen Hebe- und Senkreihenfolge später ist als die n-te, an der Vorabbildungsposition oder der Nachabbildungsposition positioniert ist, wenn der n-te Düsenhalter (47) in der Hebe- und Senkreihenfolge an der Hebe- und Senkposition positioniert ist, wobei die Vorabbildungsposition (AP1, AP2) eine Anhalteposition eine Stufe vor der Hebe- und Senkposition (HP1, HP2) ist und die Nachabbildungsposition (BP1, BP2) eine Anhalteposition eine Stufe nach der Hebe- und Senkposition (HP1, HP2) ist.

2. Vorrichtung (12) zur Montage von elektronischen Bauteilen nach Anspruch 1, wobei
mehrere Hebe- und Senkpositionen vorhanden sind,
der Hebe- und Senkabschnitt so konfiguriert ist, dass er den Düsenhalter (47) an den mehreren Hebe- und Senkpositionen einzeln hebt und senkt, und
der Abbildungsabschnitt (103) so konfiguriert ist, dass er die Saugdüse (80) in der Vorabbildungsposition und in der Nachabbildungsposition jeder der mehreren Hebe- und Senkpositionen abbildet.

3. Vorrichtung (12) zur Montage von elektronischen Bauteilen nach Anspruch 1 oder 2, ferner umfassend:
einen Bewegungsabschnitt, der so konfiguriert ist, dass er den Abbildungsabschnitt (103) so bewegt, dass sich die Vorabbildungsposition und die Nachabbildungsposition relativ zu der Hebe- und Senkposition bewegen, wobei
wenn weder der Vorabbildungsprozess noch der Nachabbildungsprozess in dem Steuerschritt enthalten ist, der den Hebe- und Senkprozess umfasst, der Steuerabschnitt so konfiguriert ist, dass er den Bewegungsabschnitt so steuert, dass die Vorabbildungsposition oder die Nachabbildungsposition an einer Position des Düsenhalters (47) positioniert ist, die als ein Ziel des Vorabbildungsprozesses oder des Nachabbildungsprozesses dient, der in dem Steuerschritt nach dem relevanten Steuerschritt enthalten ist.

4. Vorrichtung (12) zur Montage von elektronischen Bauteilen nach Anspruch 1 oder 2, wobei
das Steuergerät konfiguriert ist, um einen ersten Beurteilungsprozess auszuführen, um zu beurteilen, ob der (n - 1)-te Düsenhalter (47) an der Vorabbildungsposition oder der Nachabbildungsposition positioniert ist oder nicht, wenn der n-te Düsenhalter (47) an der Hebe- und Senkposition positioniert ist,
einen ersten Bestimmungsprozess des Bestimmens, dass der Nachabbildungsprozess des (n-1)-ten Düsenhalters (47) in dem Steuerschritt ausgeführt werden soll, in dem der Hebe- und Senkprozess des n-ten Düsenhalters (47) ausgeführt wird, wenn der (n-1)-te Düsenhalter (47) in dem ersten Beurteilungsprozess als positioniert beurteilt wird,
einen zweiten Beurteilungsprozess des Beurteilens, ob der n-te Düsenhalter (47) an der Vorabbildungsposition oder der Nachabbildungsposition positioniert ist oder nicht, wenn der (n - 1)-te Düsenhalter (47) an der Vorabbildungsposition oder der Nachabbildungsposition positioniert ist, wenn der (n - 1)-te Düsenhalter (47) in dem ersten Beurteilungsprozess als nicht positioniert beurteilt wird,
einen zweiten Bestimmungsprozess zum Bestimmen, dass der Nachabbildungsprozess des (n-1)-ten Düsenhalters (47) und der Vorabbildungsprozess des n-ten Düsenhalters (47) in dem Steuerschritt nach dem Steuerschritt auszuführen sind, in dem der Hebe- und Senkprozess des (n-1)-ten Düsenhalters (47) ausgeführt wird, wenn der n-te Düsenhalter (47) in dem zweiten Beurteilungsprozess als positioniert beurteilt wird, und
einen dritten Bestimmungsprozess des Bestimmens, dass der Nachabbildungsprozess des (n - 1)-ten Düsenhalters (47) in dem Steuerschritt nach dem Steuerschritt, in dem der Hebe- und Senkprozess des (n - 1)-ten Düsenhalters (47) ausgeführt wird, wenn der n-te Düsenhalter (47) als nicht in dem zweiten Beurteilungsprozess positioniert beurteilt wird, durchzuführen ist.

5. Verfahren zur Steuerung einer Vorrichtung (12) zur Montage von elektronischen Bauteilen, wobei
die Vorrichtung (12) zur Montage von elektronischen Bauteilen mit einem Drehkopf bereitgestellt wird, in dem mehrere Düsenhalter (47) an einem auf einer Achse zentrierten Umfang angeordnet sind und der so konfiguriert ist, dass er um die Achse schwenkt, wobei eine Saugdüse (80) von dem Düsenhalter (47) gehalten wird, die so konfiguriert ist, dass sie ein Bauteil aufnimmt, einen Hebe- und Senkabschnitt, der so konfiguriert ist, dass er den Düsenhalter (47) an einer Hebe- und Senkposition auf dem Umfang hebt und senkt, einen Abbildungsabschnitt (103), der so konfiguriert ist, dass er die Saugdüse (80) an einer Vorabbildungsposition und einer Nachabbildungsposition auf dem Umfang der Hebe- und Senkposition abbildet, und ein Steuergerät, das so konfiguriert ist, dass es eine Steuerung gemäß Auftragsdaten durchführt, bei denen eine Reihenfolge von Steuerschritten vorbestimmt ist, und
die Steuerschritte mindestens eines von Folgendem umfassen:
einen Hebe- und Senkprozess durch den Hebe- und Senkabschnitt, einen Vorabbildungsvorgang, bei dem die Saugdüse (80) durch den Abbildungsabschnitt (103) an der Vorabbildungsposition oder der Nachabbildungsposition vor Ausführung des Hebe- und Senkprozesses abgebildet wird, und einen Nachabbildungsprozess, bei dem die Saugdüse (80) durch den Abbildungsabschnitt (103) an der Vorabbildungsposition oder der Nachabbildungsposition nach Ausführung des Hebe- und Senkprozesses abgebildet wird,
**dadurch gekennzeichnet durch dass**
das Steuerverfahren umfasst:
in einem Fall, in dem eine Hebe- und Senkreihenfolge, die eine Reihenfolge des Düsenhalters (47) ist, der als ein Ziel des Hebe- und Senkprozesses in den Auftragsdaten dient, keine Anordnungsreihenfolge auf dem Umfang ist,
Ausführen des Nachabbildungsprozess, der auf den Düsenhalter (47) abzielt, und des Hebe- und Senkprozesses des n-ten Düsenhalters (47), dessen Hebe- und Senkreihenfolge n ist, in demselben Steuerschritt in einem Fall, in dem der Düsenhalter (47), dessen Hebe- und Senkreihenfolge n-1 oder früher als die n-te ist, an der Vorabbildungsposition oder der Nachabbildungsposition positioniert ist, wenn der n-te Düsenhalter (47) in der Hebe- und Senkreihenfolge an der Hebe- und Senkposition positioniert ist, und
Ausführen des auf den Düsenhalter (47) gerichteten Vorabbildungsprozesses und des Hebe- und Senkprozesses des n-ten Düsenhalters (47) im selben Steuerschritt, wenn der Düsenhalter (47), dessen Hebe- und Senkreihenfolge später als die n-te ist, an der Vorabbildungsposition oder der Nachabbildungsposition positioniert ist, wenn der n-te Düsenhalter (47) in der Hebe- und Senkreihenfolge an der Hebe- und Senkposition positioniert ist, wobei die Vorabbildungsposition (AP1, AP2) eine Anhalteposition eine Stufe vor der Hebe- und Senkposition (HP1, HP2) ist und die Nachabbildungsposition (BP1, BP2) eine Anhalteposition eine Stufe nach der Hebe- und Senkposition (HP1, HP2) ist.

## Revendications

1. Dispositif de montage de composants électroniques (12) comprenant :
une tête rotative, dans laquelle plusieurs porte-buses (47) sont disposés sur une circonférence centrée sur un axe, et qui est configurée pour pivoter autour de l'axe ;
une buse d'aspiration (80), maintenue par le porte-buse (47), qui est configurée pour prélever un composant ;
une section de levage et d'abaissement configurée pour lever et abaisser le porte-buse (47) à une position de levage et d'abaissement sur la circonférence pour prendre ou monter le composant avec la buse d'aspiration (80) ;
une section d'imagerie (103) configurée pour imager la buse d'aspiration (80) à une position de pré-imagerie et à une position de post-imagerie sur la circonférence de la position de levage et d'abaissement ; et
une section de commande configurée pour effectuer une commande basée sur des données de travail dans laquelle un ordre des étapes de commande est prédéterminé, dans lequel
les étapes de commande comprennent au moins un processus de levage et d'abaissement exécuté avec la section de levage et d'abaissement,
un processus de pré-imagerie dans lequel la buse d'aspiration (80) est imagée par la section d'imagerie (103) à la position de pré-imagerie ou à la position de post-imagerie avant l'exécution du processus de levage et d'abaissement, et
un processus de post-imagerie dans lequel la buse d'aspiration (80) est imagée par la section d'imagerie (103) à la position de pré-imagerie ou à la position de post-imagerie après l'exécution du processus de levage et d'abaissement,
**caractérisé en ce que**
dans le cas où un ordre de levage et d'abaissement qui est un ordre du porte-buse (47) servant de cible au processus de levage et d'abaissement dans les données de travail n'est pas un ordre d'arrangement sur la circonférence, la section de commande est configurée pour exécuter le processus de post-imagerie ciblant le porte-buse (47) et le processus de levage et d'abaissement du n-ième porte-buse (47) dont l'ordre de levage et d'abaissement est n, dans la même étape de commande, dans le cas où le porte-buse (47) dont l'ordre de levage et d'abaissement est n-1 ou antérieur au n-ième est positionné à la position de pré-imagerie ou de post-imagerie, lorsque le n-ième porte-buse (47) dans l'ordre de levage et d'abaissement est positionné à la position de levage et d'abaissement et que le n-ième porte-buse (47) dans l'ordre de levage et d'abaissement est positionné à la position de levage et d'abaissement, et
la section de commande est configurée pour exécuter le processus de pré-imagerie en ciblant le porte-buse (47) et le processus de levage et d'abaissement du n-ième porte-buse (47) dans la même étape de commande, dans le cas où le porte-buse (47) dont l'ordre de levage et d'abaissement du porte-buse (47) est postérieur au n-ième est positionné à la position de pré-imagerie ou à la position de post-imagerie, lorsque le n-ième porte-buse (47) dans l'ordre de levage et d'abaissement est positionné à la position de levage et d'abaissement, la position de pré-imagerie (AP1, AP2) étant une position d'arrêt un pas avant la position de levage et d'abaissement (HP1, HP2), et la position de post-imagerie (BP1, BP2) étant une position d'arrêt un pas après la position de levage et d'abaissement (HP1, HP2).

2. Dispositif de montage de composants électroniques (12) selon la revendication 1, dans lequel
il y a plusieurs positions de levage et d'abaissement,
la section de levage et d'abaissement est configurée pour lever et abaisser individuellement le porte-buse (47) dans les multiples positions de levage et d'abaissement, et
la section d'imagerie (103) est configurée pour prendre une image de la buse d'aspiration (80) à la position de pré-imagerie et à la position de post-imagerie de chacune des multiples positions de levage et d'abaissement.

3. Dispositif de montage de composants électroniques (12) selon la revendication 1 ou 2, comprenant en outre :
une section mobile configurée pour déplacer la section d'imagerie (103) de sorte que la position de pré-imagerie et la position de post-imagerie se déplacent par rapport à la position de levage et d'abaissement, dans lequel
lorsque ni le processus de pré-imagerie ni le processus de post-imagerie ne sont inclus dans l'étape de commande comprenant le processus de levage et d'abaissement, la section de commande est configurée pour commander la section mobile de sorte que la position de pré-imagerie ou la position de post-imagerie soit positionnée à une position du porte-buse (47) servant de cible au processus de pré-imagerie ou au processus de post-imagerie inclus dans l'étape de commande après l'étape de commande concernée.

4. Dispositif de montage de composants électroniques (12) selon la revendication 1 ou 2, dans lequel
la section de commande est configurée pour exécuter un premier processus de jugement consistant à déterminer si le (n-1)-ième porte-buse (47) est positionné ou non à la position de pré-imagerie ou à la position de post-imagerie lorsque le n-ième porte-buse (47) est positionné à la position de levage et d'abaissement,
un premier processus de détermination consistant à déterminer que le processus de post-imagerie du (n-1)-ième porte-buse (47) doit être exécuté dans l'étape de commande au cours de laquelle le processus de levage et d'abaissement du nième porte-buse (47) est exécuté lorsque le (n-1)-ième porte-buse (47) est jugé être positionné dans le premier processus de jugement,
un deuxième processus de jugement consistant à déterminer si le n-ième porte-buse (47) est positionné ou non à la position de pré-impression ou à la position de post-impression lorsque le (n-1)-ième porte-buse (47) est positionné à la position de pré-impression ou à la position de post-impression lorsque le (n-1)-ième porte-buse (47) est jugé comme n'étant pas positionné lors du premier processus de jugement,
un deuxième processus de détermination consistant à déterminer que le processus de post-imagerie du (n-1)-ième porte-buse (47) et le processus de pré-imagerie du n-ième porte-buse (47) doivent être exécutés dans l'étape de commande après l'étape de commande au cours de laquelle le processus de levage et d'abaissement du (n-1)-ième porte-buse (47) est exécuté lorsque le n-ième porte-buse (47) est jugé être positionné dans le deuxième processus de jugement, et
un troisième processus de détermination consistant à déterminer que le processus de post-imagerie du (n-1)-ième porte-buse (47) doit être exécuté dans l'étape de commande après l'étape de commande au cours de laquelle le processus de levage et d'abaissement du (n-1)-ième porte-buse (47) est exécuté lorsque le n-ième porte-buse (47) est jugé comme n'étant pas positionné dans le deuxième processus de jugement.

5. Procédé de commande d'un dispositif de montage de composants électroniques (12), dans lequel le dispositif de montage de composants électroniques (12) est pourvu d'une tête rotative, dans laquelle plusieurs porte-buses (47) sont disposées sur une circonférence centrée sur un axe, et qui est configurée pour pivoter autour de l'axe, une buse d'aspiration (80), étant maintenue par le porte-buse (47), qui est configurée pour saisir un composant, une section de levage et d'abaissement configurée pour lever et abaisser le porte-buse (47) à une position de levage et d'abaissement sur la circonférence, une section d'imagerie (103) configurée pour prendre une image de la buse d'aspiration (80) à une position de pré-imagerie et à une position de post-imagerie sur la circonférence de la position de levage et d'abaissement, et une section de commande configurée pour effectuer une commande selon des données de travail dans lesquelles un ordre d'étapes de commande est prédéterminé, et
les étapes de commande comprennent au moins l'un des éléments suivants :
un processus de levage et d'abaissement par la section de levage et d'abaissement, un processus de pré-imagerie dans lequel la buse d'aspiration (80) est imagée par la section d'imagerie (103) à la position de pré-imagerie ou à la position de post-imagerie avant l'exécution du processus de levage et d'abaissement, et un processus de post-imagerie dans lequel la buse d'aspiration (80) est imagée par la section d'imagerie (103) à la position de pré-imagerie ou à la position de post-imagerie après l'exécution du processus de levage et d'abaissement, et
**caractérisé par le fait que**
le procédé de commande comprenant les étapes consistant à :
dans le cas où un ordre de levage et d'abaissement qui est un ordre du porte-buse (47) servant de cible au processus de levage et d'abaissement dans les données de travail n'est pas un ordre d'agencement sur la circonférence,
exécuter le processus de post-imagerie ciblant le porte-buse (47) et le processus de levage et d'abaissement du n-ième porte-buse (47) dont l'ordre de levage et d'abaissement est n, dans la même étape de commande, dans le cas où le porte-buse (47) dont l'ordre de levage et d'abaissement est n-1 ou antérieur au n-ième est positionné à la position de pré-imagerie ou de post-imagerie, lorsque le n-ième porte-buse (47) dans l'ordre de levage et d'abaissement est positionné à la position de levage et d'abaissement et que le n-ième porte-buse (47) dans l'ordre de levage et d'abaissement est positionné à la position de levage et d'abaissement, et
exécuter le processus de pré-imagerie en ciblant le porte-buse (47) et le processus de levage et d'abaissement du n-ième porte-buse (47) dans la même étape de commande, dans le cas où le porte-buse (47) dont l'ordre de levage et d'abaissement du porte-buse (47) est postérieur au n-ième est positionné à la position de pré-imagerie ou à la position de post-imagerie, lorsque le n-ième porte-buse (47) dans l'ordre de levage et d'abaissement est positionné à la position de levage et d'abaissement, la position de pré-imagerie (AP1, AP2) étant une position d'arrêt un pas avant la position de levage et d'abaissement (HP1, HP2), et la position de post-imagerie (BP1, BP2) étant une position d'arrêt un pas après la position de levage et d'abaissement (HP1, HP2).
